(19)

Europäisches Patentamt

European Patent Office

Office européen des brevets

(11) **EP 4 733 791 A1**

(12) **EUROPÄISCHE PATENTANMELDUNG**

(43) Veröffentlichungstag:
**29.04.2026   Patentblatt 2026/18**

(21) Anmeldenummer: **25207128.7**

(22) Anmeldetag: **07.10.2025**

(51) Internationale Patentklassifikation (IPC):
**G01R 31/50** $^{(2020.01)}$        **H02H 5/10** $^{(2006.01)}$

(52) Gemeinsame Patentklassifikation (CPC):
**H02H 5/105; G01R 31/50**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH LA MA MD TN**

(30) Priorität: **23.10.2024   DE 102024130878**

(71) Anmelder: **Bender GmbH & Co. KG**
**35305 Grünberg (DE)**

(72) Erfinder: **Hackl, Dieter**
**35463 Fernwald (DE)**

(74) Vertreter: **advotec.**
**Patent- und Rechtsanwaltspartnerschaft mbB**
**Georg-Schlosser-Straße 6**
**35390 Gießen (DE)**

(54) **VERFAHREN UND VORRICHTUNGEN ZUM PRÜFEN UND ÜBERWACHEN DER DURCHGÄNGIGKEIT EINES PEN-LEITERS FÜR EIN DREIPHASIGES TN-C-S-STROMVERSORGUNGSSYSTEM**

(57)     Die Erfindung betrifft Verfahren und Vorrichtungen zum Prüfen und Überwachen der Durchgängigkeit eines PEN-Leiters für ein dreiphasiges TN-C-S-Stromversorgungssystem, an das ein Betriebsmittel ein- oder dreiphasig angeschlossen ist. Dabei wird an einem erfindungsgemäß eingerichteten, virtuellen Sternpunkt an einem Betriebsmittel mit dreiphasigen Anschlussklemmen erfindungsgemäß eine Spannungsmessung vorgenommen und die gemessene Sternpunktspannung bewertet. Falls die Sternpunktspannung eine kritische Spannung übersteigt, erfolgt eine Trennung des Betriebsmittels. Die Erfindung kommt somit ohne eine konstruktiv aufwendige Errichtung einer lokalen Referenzerde aus. Für Betriebsmittel mit einphasigen Anschlussklemmen erfolgt das Messen einer Lastspannung in einem ersten und einem zweiten Lastfall mit Berechnung einer Schleifenimpedanz aus der Spannungsänderung und einer Differenzstrom-Änderung. Der so bestimmte Schleifen-Impedanzwert erlaubt eine Aussage darüber, ob ein funktionsfähiger PEN-Leiter vorhanden ist.

Fig. 3a

**Beschreibung**

Die Erfindung betrifft Verfahren und Vorrichtungen zum Prüfen und Überwachen der Durchgängigkeit eines PEN-Leiters für ein dreiphasiges TN-C-S-Stromversorgungssystem mit Außenleitern, einem Neutralleiter (N-Leiter), einem Schutzleiter (PE-Leiter) und dem PEN-Leiter.

An dieses TN-C-S-Stromversorgungssystem kann in einem ersten Anwendungsfall ein Betriebsmittel mit dreiphasigen Anschlussklemmen (3AC-Betriebsmittel mit 3AC-Anschlussklemmen) und mit einem 3AC-Schaltglied an mindestens einen der Außenleiter, den Neutralleiter und den Schutzleiter angeschlossen sein.

Oder in einer zweiten Anwendung der Erfindung ist ein Betriebsmittel mit einphasigen Anschlussklemmen (AC-Betriebsmittel mit AC-Anschlussklemmen) an einen der Außenleiter, den Neutralleiter und den Schutzleiter angeschlossen.

Das TN-C-S-Stromversorgungssystem sowie die angeschlossenen Betriebsmittel stellen jeweils eine vorausgesetzte Anwendungsumgebung für die erfindungsgemäßen Verfahren und die diese Verfahren umsetzenden Vorrichtungen dar und sind nicht Teil der Erfindung.

Die Energieversorgung elektrischer Verbraucher erfolgt über Stromversorgungssysteme, die als Verteilsysteme in unterschiedlichen Netzformen ausgeführt sind. Vorliegend wird ein Stromversorgungssystem mit der Netzform TN-C und vorrangig mit der Netzform TN-C-S betrachtet. In dem TN-C-System ist ein PEN-Leiter gleichzeitig Neutral- und Schutzleiter. Dabei wird die Funktion des Neutralleiters und des Schutzleiters in der gesamten (TN-C) Installation oder nur abschnittsweise (TN-C-S) von dem PEN-Leiter übernommen. In dem TN-C-S-Stromversorgungssystem erfolgt die Einspeisung von dem Verteilnetzbetreiber bis zu einer Grundstücksgrenze in einem TN-C-System mit geerdetem (Transformator-)Sternpunkt über ein Anschlusskabel (z. B. Hausanschlusskabel) mit drei aktiven Leitern und dem PEN-Leiter. Der PEN-Leiter kann an mehreren Stellen geerdet sein. In der nachfolgenden Hausinstallation innerhalb eines Gebäudes wird der PEN-Leiter getrennt als PE-Leiter und N-Leiter weitergeführt.

In dem TN-C-S-System werden somit in einem übergeordneten Teilsystem (TN-C) die Neutral- und Schutzleiterfunktion über den PEN-Leiter realisiert, in nachgeordneten weiteren Teilsystemen (TN-S) sind die Neutral- und Schutzleiterfunktion getrennt in dem N-Leiter und dem PE-Leiter ausgeführt.

Unter dem Aspekt der elektrischen Sicherheit ist der Personenschutz hinsichtlich des Fehlerfalls zu betrachten, bei dem der PEN-Leiter an einer Stelle unterbrochen wird oder so geschädigt ist, dass er nicht mehr hinreichend niederohmig mit dem Transformatorsternpunkt verbunden ist, um seine Funktion zu erfüllen. Insbesondere ist der Fehlerfall zu beachten, bei dem mehrere Leitungsabschnitte mit Betriebsmitteln über einen unterbrochenen oder beschädigten PEN-Leiterabschnitt miteinander verbunden sind. Aus dem Stand der Technik werden normativ, z. B. in der UK-Norm

BS 7671, folgende Methoden zur Fehlererkennung vorgeschlagen:

- Errichten einer lokalen Erdungsanlage (externe Bezugserde, Referenzerde), Messen der Spannung zwischen dieser lokalen Erde und dem PEN-Leiter und Trennen der aktiven Leiter und der Schutzerdung, wenn diese Spannung 70V überschreitet innerhalb einer Auslösezeit von 5s.

- Bei einphasigen Installationen Messen der Spannung zwischen dem aktiven Leiter und dem N-Leiter und Trennen der aktiven Leiter und der Schutzerdung, wenn diese Spannung außerhalb eines Bereichs von 207V bis 253V liegt innerhalb einer Auslösezeit von 5s.

Die Patentschrift WO 2020/174217A1 beschreibt einen Ansatz, bei dem ein Stromsensor im Strompfad zwischen der Schutzleiteranschlussklemme eines Betriebsmittels und der im Betriebsmittel befindlichen Verbindung des Schutzleiters mit berührbaren leitfähigen Teilen (z. B. Gehäuse oder Schutzleiter im Ladekabel) positioniert wird. Bei gefährlich hohem PE-Leiterstrom erfolgt innerhalb einer Auslösezeit von 5s eine Trennung der aktiven Leiter und eine Trennung des inneren Schutzleiters. Diese Lösung funktioniert in nachteiliger Weise nur, wenn bereits ein ausreichend großer Fehlerstrom, z. B. durch einen menschlichen Körper, fließt.

Die Patentschrift EP 0 806 825 A2 stellt einen verbesserten Fehlerstromschutzschalter bereit, der in der Lage ist, Fehlerzustände bezüglich des Schutzleiters zu erkennen und eine allpolige Trennung des Hauptstromkreises herbeizuführen. Insbesondere erfolgt die Detektion von Fehlerzuständen des Schutzleiters durch die Verwendung eines Sensors, der bei Berührung mit einem potentialnahen Erdboden Schaltvorgänge auslöst. Prinzipiell wird hier die in der UK-Norm BS 7671 geforderte lokale Referenzerde durch einen Menschen ersetzt, der mit den Füßen auf Erdpotential steht und bei Berührung einer Kontaktfläche an dem Schutzschalter eine Differenzspannungsmessung zwischen der Schutzerdung der Installation und dem Erdpotential des Menschen ermöglicht.

Der vorliegenden Erfindung liegt somit die Aufgabe zugrunde, Verfahren und Vorrichtungen anzugeben, die eine zuverlässige Beurteilung der Durchgängigkeit der PEN-Leiterverbindung im Sinne einer Qualitätsprüfung erlauben, insbesondere eine zuverlässige Erkennung von PEN-Leiterzuständen ermöglichen, die geeignet sind, unter ungünstigen Lastbedingungen gefährliche Berührungsspannungen an schutzgeerdeten, berührbaren Teilen der Betriebsmittel hervorzurufen. Auf die Errichtung einer lokalen Erdungsanlage soll dabei verzichtet werden. Um den Personenschutz im Fehlerfall sicherzustellen, sollen gefährdende PEN-Leiterzustände erkannt werden, ohne dass bereits ein gefährlicher Fehlerstrom durch den menschlichen Körper fließt.

Diese Aufgabe wird in einem ersten Anwendungsfall für 3AC-Betriebsmittel mit dreiphasigen Anschlussklemmen gelöst durch Messen einer Sternpunktspannung zwischen einem an dem 3AC-Betriebsmittel eingerichteten virtuellen Sternpunkt und dem PEN-Leiter mittels einer Spannungsmesseinrichtung, durch Auswerten der gemessenen Sternpunktspannung mittels einer Auswerteeinrichtung und Senden eines Abschaltsignals an ein 3AC-Schaltglied zum Trennen der Außenleiter, des Neutralleiters und des Schutzleiters an dem 3AC-Betriebsmittel, falls die Sternpunktspannung eine kritische Spannung übersteigt.

Für das 3AC-Betriebsmittel und für andere Betriebsmittel, die jedoch 3AC-Anschlussklemmen besitzen, wird an einem erfindungsgemäß eingerichteten, virtuellen Sternpunkt an dem Betriebsmittel erfindungsgemäß eine Spannungsmessung zwischen diesem virtuellen Sternpunkt und dem PEN-Leiter mittels einer Spannungsmesseinrichtung durchgeführt (Sternpunktspannung). In diesen ersten Anwendungsfall werden sämtliche Betriebsmittel, die 3AC-Anschlussklemmen besitzen, auch wenn sie nur einphasig betrieben werden (können), als 3AC-Betriebsmittel bezeichnet.

In einer Auswerteeinrichtung wird die gemessene Sternpunktspannung bewertet. Falls die Sternpunktspannung eine kritische Spannung übersteigt, sendet die Auswerteeinrichtung ein Schaltsignal an das 3AC-Schaltglied um die Außenleiter, den Neutralleiter und den Schutzleiter an diesem 3AC-Betriebsmittel zu trennen.

Das beanspruchte Verfahren kommt somit ohne eine konstruktiv aufwendige Errichtung einer lokalen Referenzerde aus, liefert aber mit dem erfindungsgemäß eingerichteten virtuellen Sternpunkt und dem Messen der Sternpunktspannung im Hinblick auf die Beurteilung der Qualität der Schutzeigenschaften des PEN-Leiters vergleichbare Ergebnisse wie bei Verwendung einer externen, lokal verfügbaren Referenzerde.

Mit der erfindungsgemäßen Lösung gelingt eine präventive Trennung der aktiven Leiter und des Schutzleiters, bevor es zu einer gefahrbringenden Berührung spannungsführender Teile durch einen Menschen kommen kann.

In weiterer Ausgestaltung erfolgt das Messen der Sternpunktspannung indem der virtuelle Sternpunkt aus einer Zusammenschaltung von Kondensatoren mit annähernd gleicher Kapazität gebildet wird.

Bei einer weitgehend symmetrischen Belastung des Stromversorgungssystems wird die Messung der Sternpunktspannung an einem solchen virtuellen Sternpunkt durchgeführt, der aus einer Zusammenschaltung von Kondensatoren annähernd gleicher Kapazität besteht. Simulationsergebnisse zeigen, dass die Spannungsmessung in einem unsymmetrisch belasteten Stromversorgungssystem zwischen dem virtuellen Sternpunkt und dem PEN-Leiter und zwischen dem PEN-Leiter und Erde nahezu den gleichen Wert ergibt.

Bevorzugt erfolgt das Senden des Schaltsignals durch die Auswerteeinrichtung, falls als kritische Spannung ein Wert von 70V überschritten wird.

Überschreitet die Sternpunktspannung zwischen dem virtuellen Sternpunkt und dem Schutzleiteranschluss einen aus Erfahrungswerten als kritisch betrachteten Spannungswert von 70V, erfolgt erfindungsgemäß eine Trennung der aktiven Leiter (Außenleiter und Neutralleiter) und des Schutzleiters an dem dreiphasig betriebenen 3AC-Betriebsmittel bzw. an dem einphasig betriebenen Betriebsmittel, welches aber 3AC-Anschlüsse aufweist, innerhalb einer Auslösezeit von beispielsweise 5s.

In simulierten Betriebszuständen mit unterschiedlichen Lastverteilungen und variierten qualitativen Eigenschaften des PEN-Leiters konnte mit der hier vorgeschlagenen Lösung, welche erfindungsgemäß ohne extern bereitgestellte Bezugserde auskommt, hinreichend gut festgestellt werden, ob die Spannung zwischen dem fehlerhaften PEN-Leitungsabschnitt und Erde unterhalb einer kritischen Spannung von beispielsweise 70V liegt.

Ein problematischer Schutzerdungszustand durch einen unterbrochenen oder in seiner Durchgängigkeit beeinträchtigten PEN-Leiter wird somit präventiv erkannt und ein Körperstrom durch Berührung leitfähiger Teile, die gegenüber Erde unter gefährlicher Spannung stehen können, wird vermieden.

Für Betriebsmittel mit einphasigen Anschlussklemmen - in diesem zweiten Anwendungsfall als AC-Betriebsmittel bezeichnet - wird die Aufgabe gelöst durch: Messen einer ersten Lastspannung zwischen dem angeschlossenen Außenleiter und dem Neutralleiter in einem ersten Lastfall mittels einer Spannungsmesseinrichtung; Messen eines in dem Neutralleiter fließenden ersten N-Leiter Differenzstroms mittels einer Differenzstrom-Messeinrichtung in dem ersten Lastfall; Messen einer zweiten Lastspannung zwischen dem angeschlossenen Außenleiter und dem Neutralleiter in einem zweiten Lastfall mittels der Spannungsmesseinrichtung; Messen eines in dem Neutralleiter fließenden zweiten N-Leiter Differenzstroms mittels der Differenzstrom-Messeinrichtung in dem zweiten Lastfall; Berechnen einer Schleifenimpedanz aus einer Spannungsänderung, gebildet aus der ersten Lastspannung und der zweiten Lastspannung, geteilt durch eine Differenzstrom-Änderung, gebildet aus dem ersten N-Leiter Differenzstrom und dem zweiten N-Leiter Differenzstrom, mittels einer Auswerteeinrichtung; Bewerten, ob die Schleifenimpedanz einen hinreichend kleinen Schleifen-Impedanzwert aufweist mittels der Auswerteeinrichtung und Senden eines Abschaltsignals an ein AC-Schaltglied zum Trennen des angeschlossenen Außenleiters, des Neutralleiters und des Schutzleiters an dem AC-Betriebsmittel, falls der Schleifen-Impedanzwert einen Schleifen-Impedanzgrenzwert übersteigt.

Für den Anwendungsfall des einphasig angeschlossenen Betriebsmittels (AC-Betriebsmittel) - welches voraussetzungsgemäß keine 3AC-Anschlussklemmen aufweist, an denen ein virtueller Sternpunkt eingerichtet werden könnte - liegt dem erfindungsgemäßen Verfahren die Idee zugrunde, die über einer Last (AC-Betriebsmittel oder ein Messwiderstand) abfallende Lastspannung zwischen dem angeschlossenen Außenleiter und dem Neutralleiter sowie ein in dem Neutralleiter fließenden N-Leiter-Differenzstrom in zwei Lastfällen zu messen und daraus eine - von den Klemmen der angeschlossenen Last betrachtete - Schleifenimpedanz abzuschätzen. Der so bestimmte Schleifen-Impedanzwert erlaubt eine Aussage darüber, ob ein funktionsfähiger PEN-Leiter vorhanden ist.

In dem ersten Lastfall wird die erste Lastspannung, sowie der erste N-Leiter-Differenzstrom gemessen. Nach einem Lastwechsel erfolgt unter der zweiten Last die Messung der zweiten Lastspannung und des zweiten N-Leiter-Differenzstroms. Aus der Spannungsänderung, gebildet aus der ersten Lastspannung und der zweiten Lastspannung, geteilt durch die Differenzstrom-Änderung, gebildet aus dem ersten N-Leiter-Differenzstrom und dem zweiten N-Leiter-Differenzstrom, wird die Schleifenimpedanz berechnet.

Weist diese Schleifenimpedanz einen nicht hinreichend kleinen Schleifen-Impedanzwert auf - ein solcher hinreichend kleiner Schleifen-Impedanzwert ergibt sich nur in Parallelschaltung mit einem vorhandenen, also intakten PEN-Leiter - so sendet die Auswerterichtung ein Schaltsignal an das AC-Schaltglied zum Trennen des angeschlossenen AC-Betriebsmittels.

Mit dem für einphasig angeschlossene Betriebsmittel beanspruchten Verfahren ist gegenüber dem Stand der Technik eine zuverlässige präventive Fehlererkennung und eine Abschaltung im Fehlerfall auch ohne die Gefahr von gefährlichen Körperströmen möglich.

Darüber hinaus ermöglicht die Differenzstrom-Messeinrichtung eine kombinierte Last- und Fehlerstrommessung, um sowohl eine Schleifenimpedanz-Ermittlung als auch eine Notabschaltung bei einem zu hohen Fehlerstrom zu realisieren.

In weiterer Ausgestaltung wird der erste Lastfall durch Öffnen des AC-Schaltglieds des AC-Betriebsmittels (6) und der zweite Lastfall durch Schließen des AC-Schaltglieds des AC-Betriebsmittels (6) geschaltet.

Im einfachsten Fall wird das AC-Schaltglied (Lastschalter) des einphasig angeschlossenen AC-Betriebsmittels verwendet, um durch Öffnen und Schließen des AC-Schaltgliedes den Lastwechsel zu erzeugen, wobei das AC-Betriebsmittel selbst als Last wirkt.

Alternativ zu dem Öffnen und Schließen des AC-Schaltglieds des AC-Betriebsmittels wird der erste und der zweite Lastfall durch Öffnen und Schließen eines gesonderten, zwischen einem der Außenleiter und dem Neutralleiter angeordneten, Messzweigs mit einem Messwiderstand und einem Schalter geschaltet.

Wenn technische Bedenken oder betriebliche Gründe vorliegen, nicht das AC-Schaltglied des AC-Betriebsmittels direkt für die Schleifenimpedanz-Messung zu verwenden, kann der erforderliche Lastwechsel durch einen gesonderten Messkreis erfolgen.

Im diesem Fall wird die erste/zweite Lastspannung sowie der erste/zweite N-Leiter-Differenzstrom durch Öffnen und Schließen des gesonderten Messzweiges mittels eines Schalters in dem Messkreis bewirkt, wobei der Messwiderstand in dem Messzweig die Last bildet.

Die weiteren beanspruchten strukturellen Merkmale der erfindungsgemäßen Vorrichtungen führen jeweils die entsprechenden Verfahrensschritte der erfindungsgemäßen Verfahren aus. Somit treffen die mit den Verfahren erzielten technischen Wirkungen und die daraus resultierenden Vorteile gleichermaßen auf die Vorrichtungen zu.

Weitere vorteilhafte Ausgestaltungsmerkmale ergeben sich aus der nachfolgenden Beschreibung und den Zeichnungen, die eine bevorzugte Ausführungsform der Erfindung anhand von beispielhaften Simulationsanordnungen erläutern. Es zeigen

**Fig. 1a, 1b:** ein 3AC-TN-C-S Stromversorgungssystem im fehlerfreien Fall (Fig. 1a) und bei Unterbrechung des PEN-Leiters (Fig. 1b),

**Fig. 2:** das 3AC-TN-C-S Stromversorgungssystem bei Unterbrechung des PEN-Leiters und inaktivem AC-Betriebsmittel bei Berührung eines schutzgeerdeten Gehäuses, welches eine gefährliche Spannung gegen Erde annimmt,

**Fig. 3a, 3b:** das 3AC-TN-C-S Stromversorgungssystem mit erfindungsgemäß eingerichtetem virtuellen Sternpunkt für 3AC-Betriebsmittel mit dreiphasigen Anschlussklemmen bei Unterbrechung des PEN-Leiters und bei aktivem (Fig. 3a) und inaktivem (Fig. 3b) 3AC-Betriebsmittel,

**Fig. 4a, 4b:** das 3AC-TN-C-S Stromversorgungssystem mit erfindungsgemäßem Lastwechsel für AC-Betriebsmittel mit einphasigen Anschlussklemmen bei Unterbrechung des PEN-Leiters im ersten Lastfall (Fig. 4a) und im zweiten Lastfall (Fig. 4b),

**Fig. 5:** das 3AC-TN-C-S Stromversorgungssystem mit erfindungsgemäßem Lastwechsel für AC-Betriebsmittel mit einphasigen Anschlussklemmen bei beeinträchtigtem PEN-Leiter und bei Berührung,

**Fig. 6a, 6b:** das 3AC-TN-C-S Stromversorgungssystem mit erfindungsgemäßem Lastwechsel und Messzweig für AC-Betriebsmittel mit einphasigen Anschlussklemmen bei intaktem PEN-Leiter im ersten Lastfall (Fig. 6a) und im zweiten Lastfall (Fig. 6b).

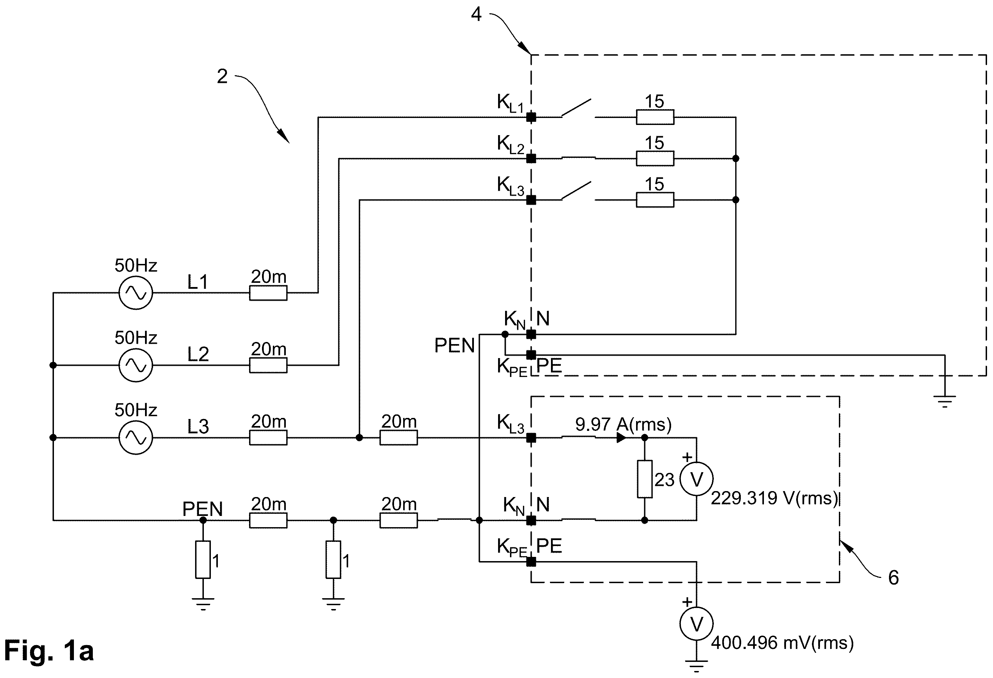

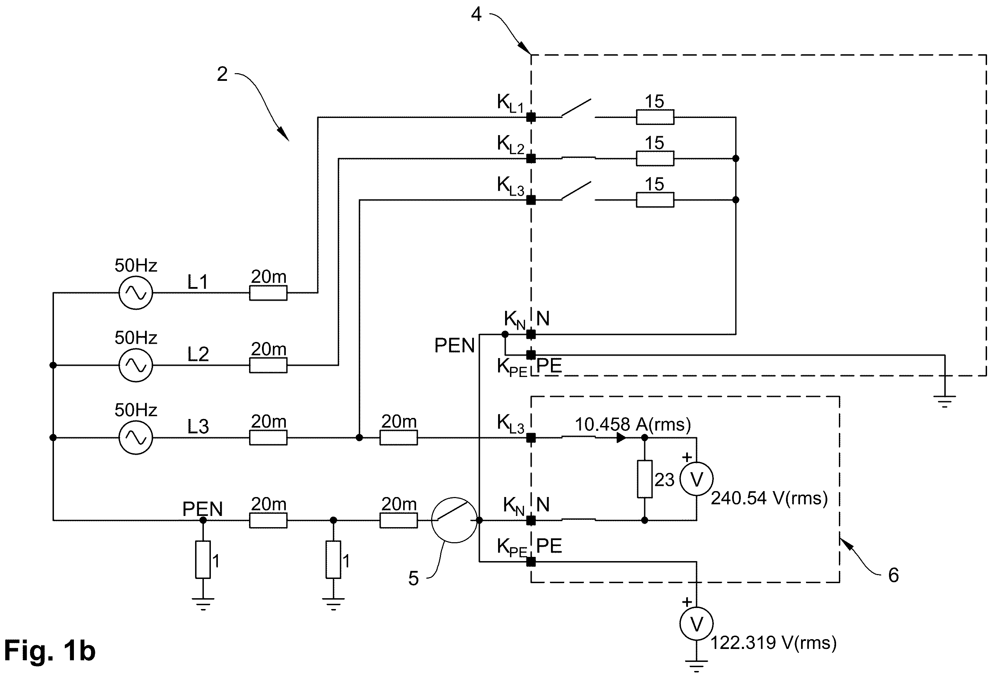

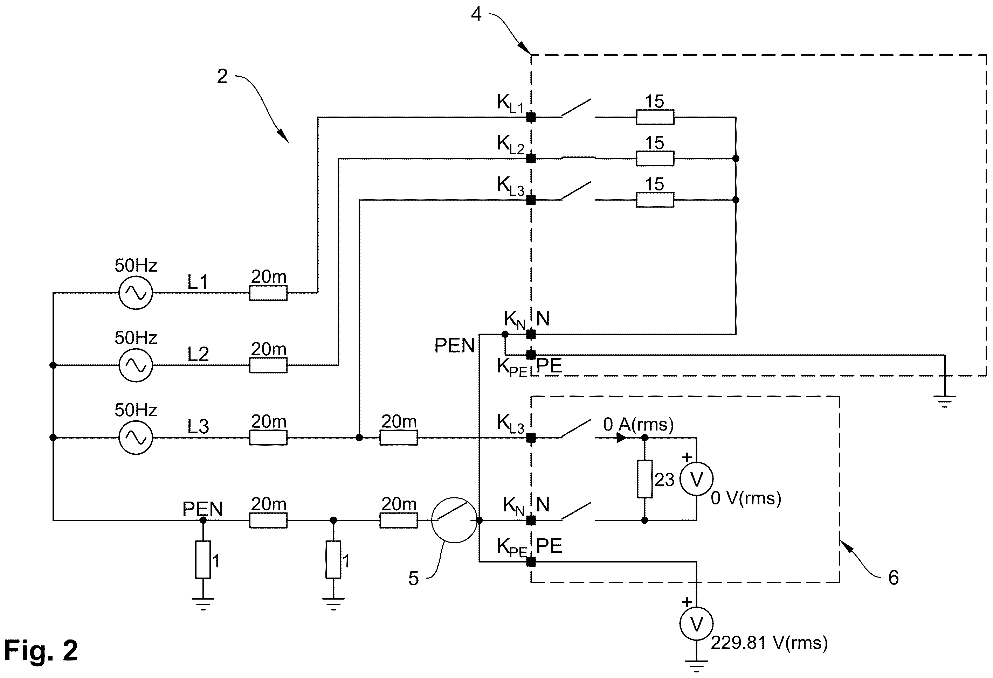

Die **Fig. 1a, 1b und 2** zeigen Simulationsanordnungen mit Ergebnissen der Strom- und Spannungsverteilung für ein 3AC-TN-C-S Stromversorgungssystems 2, an das beispielhaft ein 3AC-Betriebsmittel 4 und ein AC-Betriebsmittel 6 angeschlossen sind. Die in den Fig. 1a, 1b und 2 dargestellten Simulationsanordnungen bilden vorausgesetzte Anwendungsumgebungen für die erfindungsgemäßen Verfahren und Vorrichtungen zum Prüfen und Überwachen der Durchgängigkeit eines PEN-Leiters PEN.

**Fig. 1a** zeigt ein dreiphasiges (3AC) TN-C-S Stromversorgungssystem 2 im fehlerfreien Fall. In **Fig. 1b** ist das TN-C-S Stromversorgungssystem 2 in dem Fehlerfall mit einer Unterbrechung 5 des PEN-Leiters PEN dargestellt.

Das TN-C-S Stromversorgungssystem ist an dem Einspeisepunkt als TN-C System mit geerdetem Transformatorsternpunkt ausgebildet. Der PEN-Leiter PEN ist in diesem Teilsystem gleichzeitig Neutralleiter N und Schutzleiter PE. In dem sich anschließenden TN-S-System ist der PEN-Leiter PEN in den Neutralleiter N und den Schutzleiter PE aufgeteilt - in der Simulationsanordnung wird die Trennung an dem jeweiligen Betriebsmittel 4, 6 vorgenommen.

Das 3AC-Betriebsmittel 4 besitzt in Form eines dreiphasigen 3AC-Anschlussklemmenblocks 3AC-Anschlussklemmen $K_{L1}$, $K_{L2}$, $K_{L3}$, $K_N$, $K_{PE}$, die mit den Außenleitern L1, L2, L3, dem Neutralleiter N und dem Schutzleiter PE verbunden werden können. In der Simulation ist vereinfachend nur der Außenleiter (Phase) L2 aufgeschaltet, sodass nur die daran angeschlossene Last wirksam ist.

Das AC-Betriebsmittel 6 besitzt in Form eines einphasigen AC-Anschlussklemmenblocks AC-Anschlussklemmen $K_{L3}$, $K_N$, $K_{PE}$ und ist an den Außenleiter L3, den Neutralleiter N und den Schutzleiter PE angeschlossen. Der Körper dieses AC-Betriebsmittels 6 könnte beispielsweise die Karosserie eines Elektrofahrzeugs sein, dessen Energiespeicher an einer Ladestation geladen wird.

Wird die Karosserie des Elektrofahrzeugs von einem Menschen berührt, so sind im fehlerfreien Zustand (Fig. 1a) nur ungefährliche Kleinspannungen (400mV) zu erwarten, im fehlerhaften Zustand mit einer Unterbrechung 5 (Fig. 1b) des PEN-Leiters PEN können jedoch gefährlich hohe Spannungen (122V) gegen Erde entstehen, die bei dem Menschen gesundheitsgefährdende physiologische Wirkungen bis hin zu einem Herzstillstand verursachen können.

Aus den Simulationen geht hervor, dass es bei einer Unterbrechung 5 des PEN-Leiters PEN zu ungünstigen Lastverteilungen in denjenigen Anlagenteilen kommen kann, die ebenfalls an den Leitungsabschnitt des unterbrochenen PEN-Leiters PEN angeschlossen sind, was dazu führen kann, dass an berührbaren, leitfähigen Teilen, die schutzgeerdet sind, eine gefährliche Spannung (122V, Fig. 1b) gegen Erde auftritt, während die Spannung (240V) zwischen dem Außenleiter L3 und dem N-Leiter N an dem AC-Betriebsmittel 6 noch in einem Normbereich von 207V bis 253V liegt.

**Fig. 2** zeigt das 3AC-TN-C-S Stromversorgungssystem 2 bei Unterbrechung 5 des PEN-Leiters PEN und inaktivem AC-Betriebsmittel 6 (Ladestation) bei Berührung eines schutzgeerdeten Gehäuses, welches eine gefährliche Spannung gegen Erde annimmt.

Die Simulationen ergeben, dass bei einer Unterbrechung 5 des PEN-Leiters PEN im ungünstigsten Fall auch bei inaktivem (getrenntem) AC-Betriebsmittel 6 (Ladestation) an berührbaren leitfähigen Teilen, die mit dem PEN-Leiter PEN verbunden sind, eine gefährliche Spannung (229 V) auftreten kann.

Da die Ladestation 6 in diesem Fall bereits abgeschaltet ist, ist ein zusätzlicher Schutz durch eine Fehlerstrom-Schutzeinrichtung (RCD) in diesem Fall nicht sinnvoll. Eine Fehlerstrom-Schutzeinrichtung (RCD) würde bestimmungsgemäß die aktiven Leiter L3, N trennen und könnte somit in ungünstigen Fällen durch diese Trennung, da dann kein Strom über die Ladestation 6 fließen kann, sogar eine Berührungsspannung erhöhen. Die gefährdenden physiologischen Wirkungen auf den menschlichen Körper würden verschlimmert werden, wenn eine Fahrzeugkarosserie berührt wird, die bei gestecktem Ladestecker auch im inaktiven Zustand mit dem PEN-Leiter PEN verbunden ist.

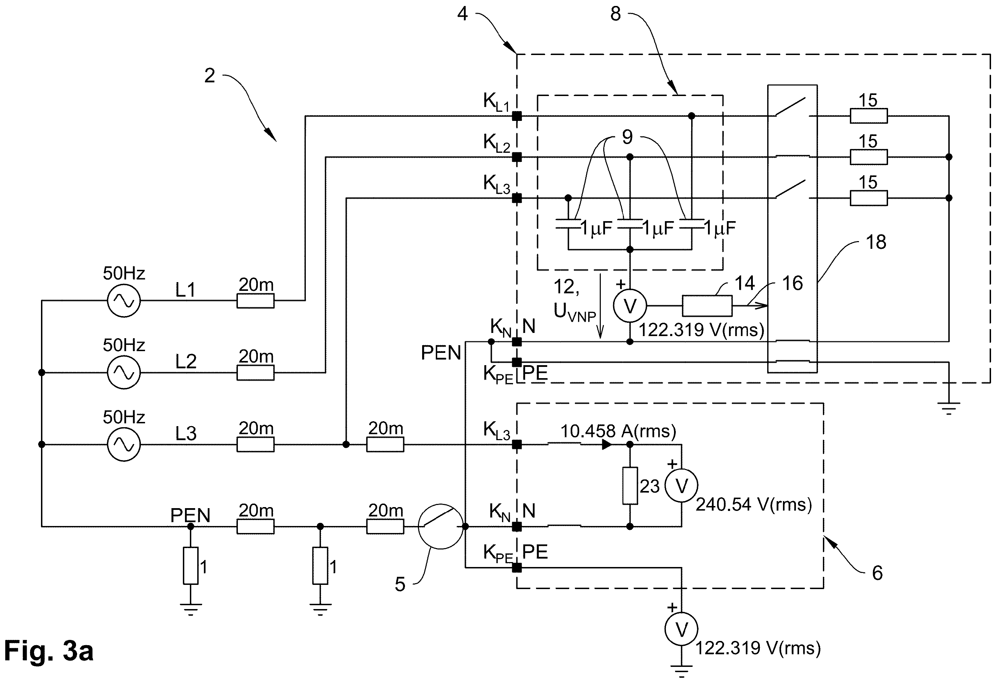

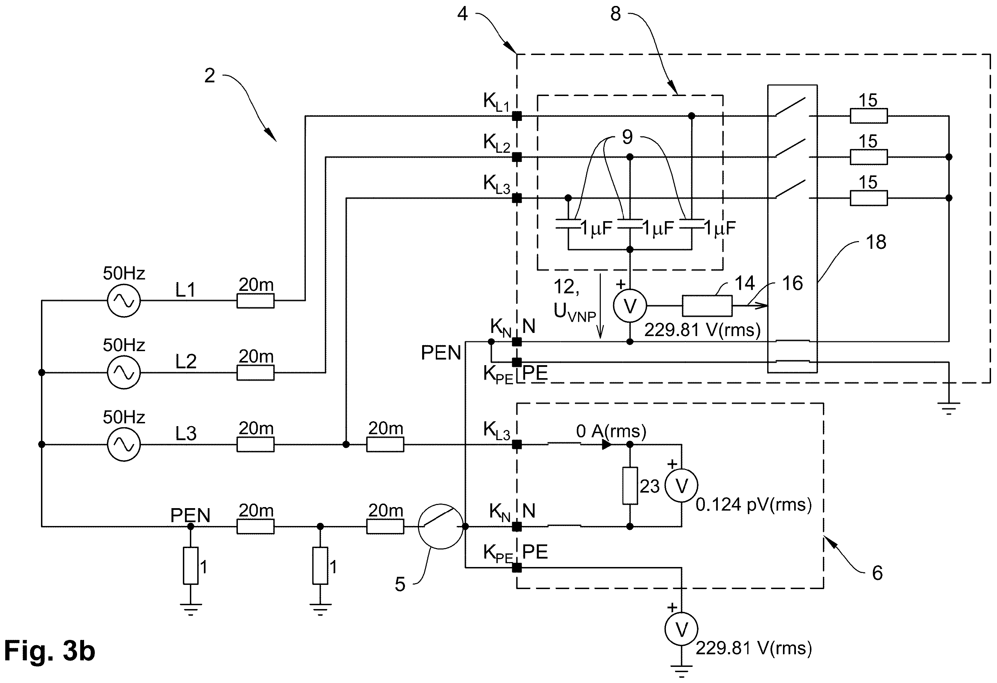

Die **Fig. 3a, 3b** zeigen das 3AC-TN-C-S Stromversorgungssystem 2 mit erfindungsgemäß eingerichtetem virtuellen Sternpunkt 8 für ein 3AC-Betriebsmittel 4 mit dreiphasigen Anschlussklemmen $K_{L1}$, $K_{L2}$, $K_{L3}$, $K_N$, $K_{PE}$ bei Unterbrechung 5 des PEN-Leiters PEN und bei aktivem (Fig. 3a) und inaktivem (Fig. 3b) 3AC-Betriebsmittel 4.

Der virtuelle Sternpunkt 8 ist aus einer Zusammenschaltung von Kondensatoren 9 gebildet, die annähernd die gleiche Kapazität besitzen. Mit der Errichtung des virtuellen Sternpunkts 8 kann auf den aufwendigen Aufbau einer lokalen Erdungsanlage (externen Referenzerde) verzichtet werden.

Die Simulationen zeigen, dass das Messergebnis für die mittels einer Spannungsmesseinrichtung 12 zwischen dem an dem 3AC-Betriebsmittel 4 eingerichteten virtuellen Sternpunkt 8 und dem PEN-Leiter PEN gemessene Sternpunktspannung $U_{VNP}$ mit 122V (Fig. 3a) und 229V (Fig. 3b) sowohl bei aktivem 3AC-Betriebsmittel 4 als auch bei inaktivem 3AC-Betriebsmittel 4 deutlich über einer kritischen Spannung $U_{lim}$ von 70V liegt.

Die Auswerteeinrichtung 14 erfasst die Sternpunktspannung $U_{VNP}$, wertet diese aus und sendet bei Überschreitung der kritischen Spannung $U_{lim}$ ein Abschaltsignal 16 an ein 3AC-Schaltglied 18 zur Trennung der Außenleiter L1, L2, L3, des Neutralleiters N und des Schutzleiters PE an dem 3AC-Betriebsmittel 4.

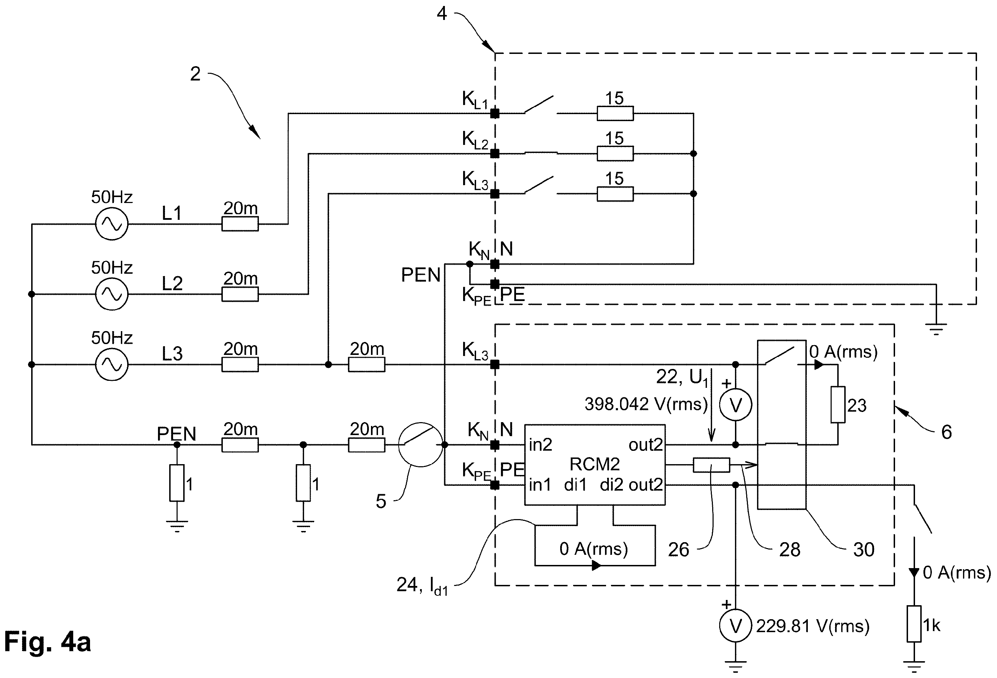

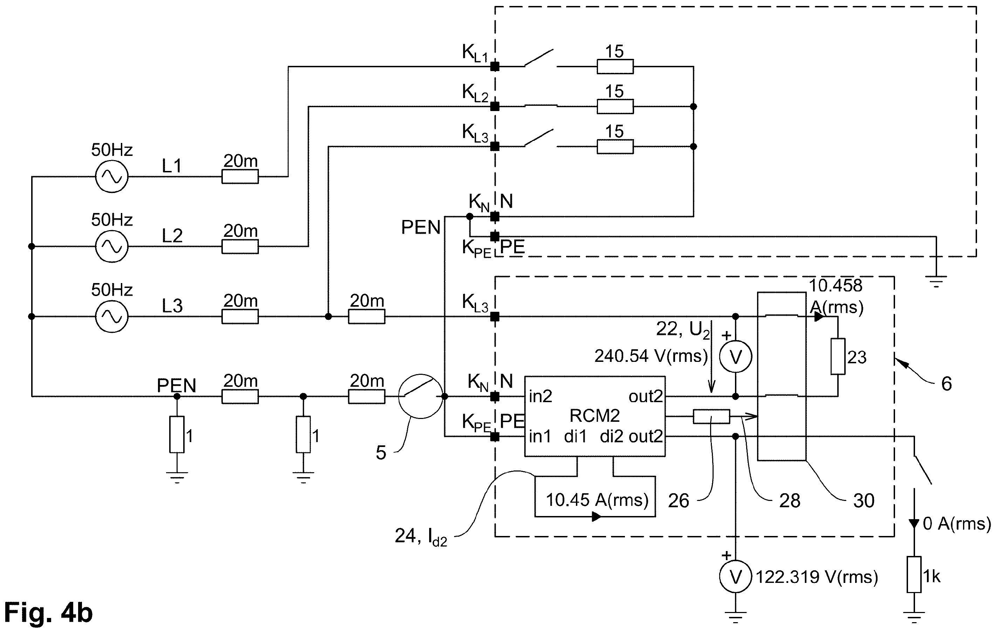

In den **Fig. 4a, 4b** ist eine erfindungsgemäße Lösung für ein AC-Betriebsmittel 6 mit einphasigen AC-Anschlussklemmen $K_{L3}$, $K_N$, $K_{PE}$ bei Unterbrechung 5 des PEN-Leiters PEN dargestellt.

Erfindungsgemäß findet ein Lastwechsel zwischen einem ersten Lastfall (Fig. 4a) und einem zweiten Lastfall (Fig. 4b) statt.

In dem ersten Lastfall ist das AC-Schaltglied 30 an dem AC-Betriebsmittel 6 geöffnet. Daher fließt kein Laststrom über das AC-Betriebsmittel 6 und mittels der Spannungsmesseinrichtung 22 wird eine erste Lastspannung $U_1$ (398V) gemessen. Die Differenzstrom-Messeinrichtung 24 zeigt an, dass kein erster N-Leiter Differenzstrom $I_{d1}$ (0A) fließt.

Nach Schließen des AC-Schaltglieds 30 an dem AC-Betriebsmittel 6 stellen sich in dem zweiten Lastfall die zweite Lastspannung $U_2$ (240V) und der zweite N-Leiter Differenzstrom $I_{d2}$ (10.5A) ein.

Aus der Spannungsänderung $\Delta U$ und der Differenzstrom-Änderung $\Delta I$, die sich bei dem Lastwechsel ergeben, kann die Schleifenimpedanz $Z_{Loop}$ (Schleifen-Impedanzwert) abgeschätzt werden:

$$Z_{Loop} = \frac{\Delta U}{\Delta I} = \frac{398V - 240.5V}{10.5A} \approx 15\Omega$$

Da der PEN-Leiter PEN in dem gezeigten Fall durch die Unterbrechung 5 hochohmig aufgetrennt wurde, wird die Schleifenimpedanz $Z_{Loop}$ nur durch die an den Außenleiter L2 angeschlossene Last des 3AC-Betriebsmittels 4 gebildet, das an den gemeinsamen Teil des unterbrochenen PEN-Leiters PEN angeschlossen ist. Daraus kann geschlossen werden, dass keine weitere, parallele niederohmige Verbindung durch einen funktionsfähigen PEN-Leiter PEN vorhanden ist, somit eine Unterbrechung 5 des PEN-Leiter PEN vorliegt.

Die Auswerteeinrichtung 26 nimmt diese Bewertung vor und sendet ein Abschaltsignal 28 an das AC-Schaltglied 30 zur Trennung des angeschlossenen Außenleiters L3, des Neutralleiters N und des Schutzleiters PE an dem AC-Betriebsmittel 6.

Es kann damit eine robuste Abschätzung über einen kritischen Zustand des PEN-Leiters PEN getroffen werden und die Trennung des AC-Betriebsmittels 6 kann z. B. innerhalb einer Auslösezeit von 5s bewirkt werden.

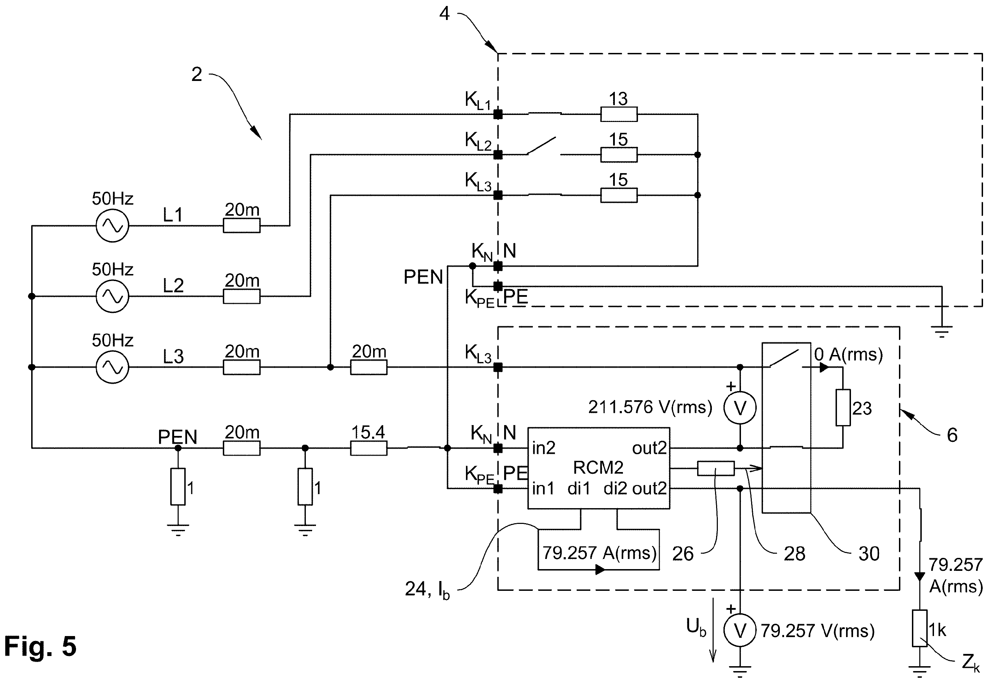

**Fig. 5** zeigt das 3AC-TN-C-S Stromversorgungssystem 2 mit erfindungsgemäßem Lastwechsel für AC-Betriebsmittel 6 mit einphasigen Anschlussklemmen $K_{L3}$, $K_N$, $K_{PE}$ bei beeinträchtigtem PEN-Leiter PEN und bei Berührung.

Der menschliche Körper wird durch eine Körperimpedanz $Z_k$ (1kΩ) dargestellt und der PEN-Leiter PEN ist hier nicht komplett unterbrochen, hat aber einen unzulässig hohen Wert von 15,4Ω.

Im inaktiven Zustand des einphasigen Betriebsmittels 6, also bei geöffnetem AC-Schaltglied 30 kann über die Differenzstrom-Messeinrichtung 24 der Fehlerstrom über eine Person im Berührungsfall (Berührungsstrom $I_b$) ermittelt werden. Auch hier kann bereits eine Trennung der aktiven Leiter und der Schutzerde z. B. innerhalb einer Auslösezeit von 5s erreicht werden.

Die Spannung zwischen dem Außenleiter L3 und dem Neutralleiter N liegt im Bereich von 207V bis 253V. Die Berührspannung $U_b$ an dem schutzgeerdeten AC-Betriebsmittel 6 gegen Erde ist größer als 70V.

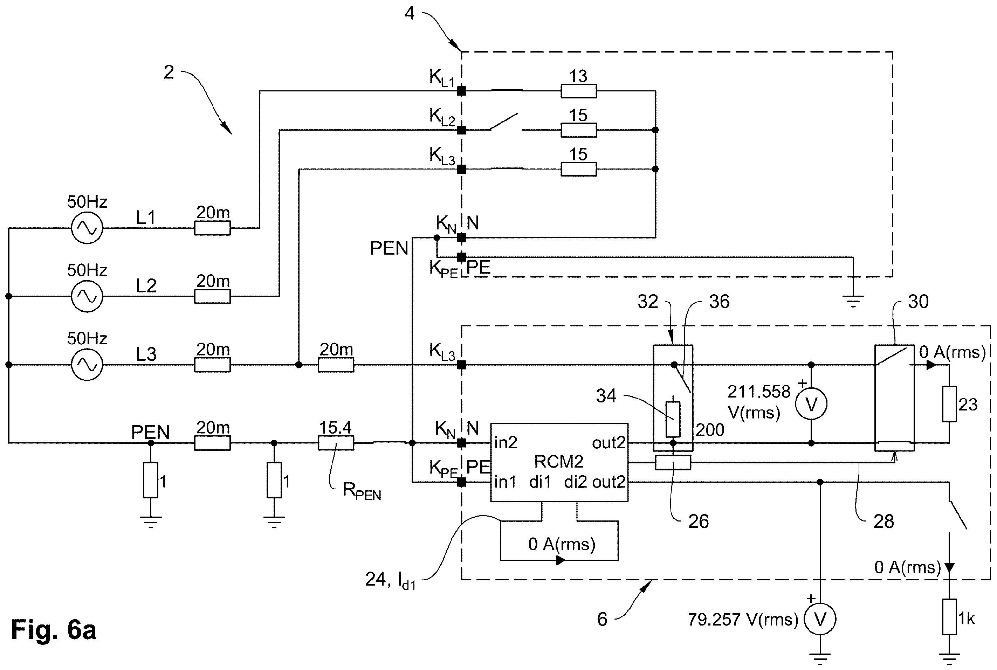

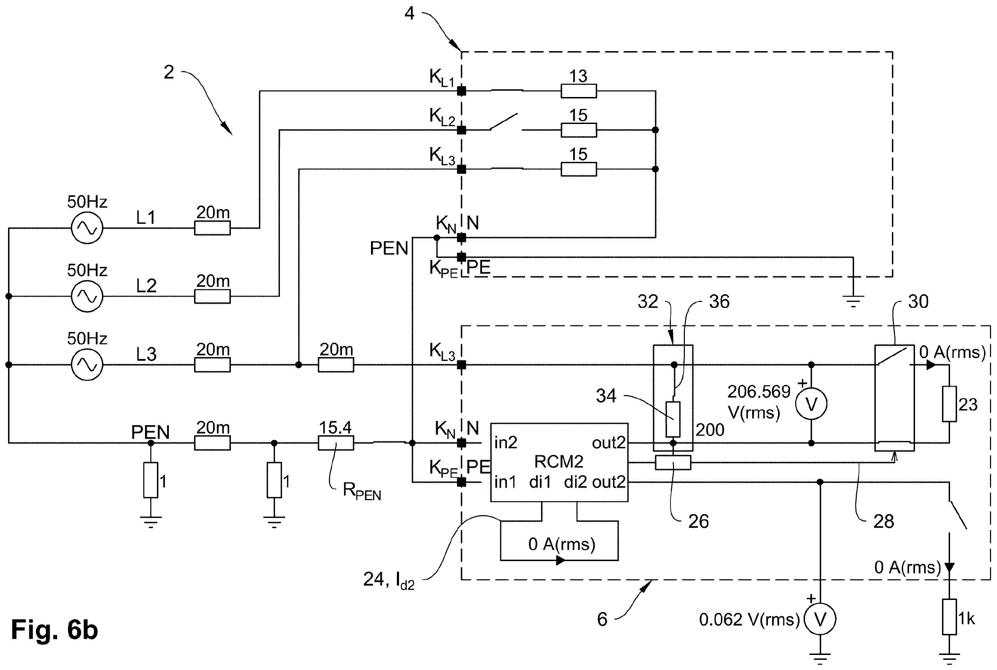

Die **Fig. 6a, 6b** zeigen das 3AC-TN-C-S Stromversorgungssystem 2 mit erfindungsgemäßem Lastwechsel und Messzweig 32 für AC-Betriebsmittel 6 mit einphasigen Anschlussklemmen $K_{L3}$, $K_N$, $K_{PE}$ bei intaktem PEN-Leiter PEN im ersten Lastfall (Fig. 6a) und im zweiten Lastfall (Fig. 6b).

Im Unterschied zu den Darstellungen in Fig. 4a, 4b, die eine Unterbrechung des PEN-Leiters PEN dokumentieren, weist der PEN-Leiter PEN in dieser Simulation zum Nachweis seiner Funktionsfähigkeit keine Unterbrechung auf.

Der Lastwechsel wird durch Öffnen und Schließen eines Schalters 36 in einem gesonderten, zwischen einem der Außenleiter L3 und dem Neutralleiter N angeordneten, Messzweig 32 hergestellt, wobei die Last durch einen Messwiderstand 34 gebildet wird.

In dem ersten Lastfall (Fig. 6a) bei geöffnetem Schalter 36 stellt sich die erste Lastspannung $U_1$ (211.6V), in dem zweiten Lastfall (Fig. 6b) die zweite Lastspannung $U_2$ (206.6V) zwischen aktivem Leiter L3 und dem Neutralleiter N ein. Der erfasste erste bzw. zweite N-Leiter Differenzstrom $I_{d1}$ bzw. $I_{d2}$ beträgt 0A bzw. 1.03A.

Die Schleifenimpedanz $Z_{Loop}$ (Schleifen-Impedanzwert) wird wie folgt abgeschätzt:

$$Z_{Loop} = \frac{\Delta U}{\Delta I} = \frac{211.6V - 206.6V}{1.03A} \approx 4.85\Omega$$

Da der PEN-Leiter PEN im gezeigten Fall mit einen (erhöhten) PEN-Leiter-Widerstandswert $R_{PEN}$ (15,4Ω) simuliert wurde, wird die Schleifenimpedanz $Z_{Loop}$ durch die Parallelschaltung der Lasten auf den Außenleitern L1 und L3 des 3AC-Betriebsmittels 4 sowie dem PEN-Leiter-Widerstand gebildet.

Rechnerisch ist folgender Wert zu erwarten:

$$Z_{Loop} = \frac{1}{\frac{1}{13\Omega} + \frac{1}{15\Omega} + \frac{1}{15.4\Omega}} \approx 4.83\Omega$$

Bei Installationen, die mit 16A abgesichert sind, sollte die Schleifenimpedanz $Z_{Loop}$ unterhalb von ca. 2Ω liegen.

**Patentansprüche**

1. Verfahren zum Prüfen und Überwachen der Durchgängigkeit eines PEN-Leiters (PEN) für ein dreiphasiges TN-C-S-Stromversorgungssystem (2) mit Außenleitern (L1, L2, L3), einem Neutralleiter (N), einem Schutzleiter (PE) und dem PEN-Leiter (PEN), an welches ein 3AC-Betriebsmittel (4) mit dreiphasigen 3AC-Anschlussklemmen ($K_{L1}$, $K_{L2}$, $K_{L3}$, $K_N$, $K_{PE}$) an mindestens einen der Außenleiter (L1, L2, L3), den Neutralleiter (N) und den Schutzleiter (PE) angeschlossen ist, umfassend die Verfahrensschritte:

Messen einer Sternpunktspannung ($U_{VNP}$) zwischen einem an dem 3AC-Betriebsmittel (4) eingerichteten virtuellen Sternpunkt (8) und dem PEN-Leiter (PEN) mittels einer Spannungsmesseinrichtung (12), Auswerten der gemessenen Sternpunktspannung ($U_{VNP}$) mittels einer Auswerteeinrichtung (14) und Senden eines Abschaltsignals (16) an ein 3AC-Schaltglied (18) zum Trennen der Außenleiter (L1, L2, L3), des Neutralleiters (N) und des Schutzleiters (PE) an dem 3AC-Betriebsmittel (4), falls die Sternpunktspannung ($U_{VNP}$) eine kritische Spannung ($U_{lim}$) übersteigt.

2.  Verfahren nach Anspruch 1,
    **dadurch gekennzeichnet,**
    **dass** das Messen der Sternpunktspannung ($U_{VNP}$) erfolgt indem der virtuelle Sternpunkt (8) aus einer Zusammenschaltung von Kondensatoren (9) mit annähernd gleicher Kapazität gebildet wird.

3.  Verfahren nach Anspruch 1 oder 2,
    **dadurch gekennzeichnet,**
    **dass** Senden des Abschaltsignals durch die Auswerteeinrichtung (14) erfolgt, falls als kritische Spannung ($U_{lim}$) ein Wert von 70V überschritten wird.

4.  Verfahren zum Prüfen und Überwachen der Durchgängigkeit eines PEN-Leiters (PEN) für ein dreiphasiges TN-C-S-Stromversorgungssystem (2) mit Außenleitern (L1, L2, L3), einem Neutralleiter (N), einem Schutzleiter (PE) und dem PEN-Leiter (PEN), an welches ein AC-Betriebsmittel (6) mit einphasigen AC-Anschlussklemmen ($K_{L3}$, $K_N$, $K_{PE}$) an einen der Außenleiter (L3), den Neutralleiter (N) und den Schutzleiter (PE) angeschlossen ist, umfassend die Verfahrensschritte:

Messen einer ersten Lastspannung ($U_1$) zwischen dem angeschlossenen Außenleiter (L3) und dem Neutralleiter (N) in einem ersten Lastfall mittels einer Spannungsmesseinrichtung (22),
Messen eines in dem Neutralleiter (N) fließenden ersten N-Leiter Differenzstroms ($I_{d1}$) mittels einer Differenzstrom-Messeinrichtung (24) in dem ersten Lastfall,
Messen einer zweiten Lastspannung ($U_2$) zwischen dem angeschlossenen Außenleiter (L3) und dem Neutralleiter (N) in einem zweiten Lastfall mittels der Spannungsmesseinrichtung (22),

Messen eines in dem Neutralleiter (N) fließenden zweiten N-Leiter Differenzstroms ($I_{d2}$) mittels der Differenzstrom-Messeinrichtung (24) in dem zweiten Lastfall,
Berechnen einer Schleifenimpedanz ($Z_{Loop}$) aus einer Spannungsänderung ($\Delta U$), gebildet aus der ersten Lastspannung ($U_1$) und der zweiten Lastspannung ($U_2$), geteilt durch eine Differenzstrom-Änderung ($\Delta I$), gebildet aus dem ersten N-Leiter Differenzstrom ($I_{d1}$) und dem zweiten N-Leiter Differenzstrom ($I_{d2}$), mittels einer Auswerteeinrichtung (26),
Bewerten, ob die Schleifenimpedanz einen hinreichend kleinen Schleifen-Impedanzwert aufweist mittels der Auswerteeinrichtung (26) und Senden eines Abschaltsignals (28) an ein AC-Schaltglied (30) zum Trennen des angeschlossenen Außenleiters (L3), des Neutralleiters (N) und des Schutzleiters (PE) an dem AC-Betriebsmittel (6), falls der Schleifen-Impedanzwert einen Schleifen-Impedanzgrenzwert ($Z_{lim}$) übersteigt.

5.  Verfahren nach Anspruch 4,
    **dadurch gekennzeichnet,**
    **dass** der erste Lastfall durch Öffnen des AC-Schaltglieds (30) des AC-Betriebsmittels (6) und der zweite Lastfall durch Schließen des AC-Schaltglieds (30) des AC-Betriebsmittels (6) geschaltet wird.

6.  Verfahren nach Anspruch 4,
    **dadurch gekennzeichnet,**
    **dass** der erste und der zweite Lastfall durch Öffnen und Schließen eines gesonderten, zwischen einem der Außenleiter (L3) und dem Neutralleiter (N) angeordneten, Messzweigs (32) mit einem Messwiderstand (34) und einem Schalter (36) geschaltet werden.

7.  Verfahren nach einem der Ansprüche 4 bis 6,
    **dadurch gekennzeichnet,**
    **dass** ein Berührungsstrom an dem inaktivem AC-Betriebsmittel (6) gemessen wird.

8.  Vorrichtung zum Prüfen und Überwachen der Durchgängigkeit eines PEN-Leiters (PEN) für ein dreiphasiges TN-C-S-Stromversorgungssystem (2) mit Außenleitern (L1, L2, L3), einem Neutralleiter (N), einem Schutzleiter (PE) und dem PEN-Leiter (PEN), an welches ein 3AC-Betriebsmittel (4) dreiphasig über 3AC-Anschlussklemmen ($K_{L1}$, $K_{L2}$, $K_{L3}$, $K_N$, $K_{PE}$) an die Außenleiter (L1, L2, L3), den Neutralleiter (N) und den Schutzleiter (PE) angeschlossen ist, mit einem 3AC-Schaltglied (18) zur Trennung des 3AC-Betriebsmittels (4),
    **gekennzeichnet durch**
    einen an dem 3AC-Betriebsmittel (4) eingerichteten virtuellen Sternpunkt (8), eine Spannungsmesseinrichtung (12) zur Messung einer Sternpunktspannung ($U_{VNP}$) zwischen dem virtuellen Sternpunkt und dem PEN-Leiter (PEN), eine Auswerteeinrichtung (14), welche ausgelegt ist zur Auswertung der gemessenen Sternpunktspannung ($U_{VNP}$) und zum Senden eines Abschaltsignals (16) an das 3AC-Schaltglied (18) zur Trennung der Außenleiter (L1, L2, L3), des Neutralleiters (N) und des Schutzleiters (PE) an dem 3AC-Betriebsmittel (4), falls die Sternpunktspannung ($U_{VNP}$) eine kritische Spannung ($U_{lim}$) übersteigt.

9. Vorrichtung nach Anspruch 8,
   **dadurch gekennzeichnet,**
   **dass** der virtuelle Sternpunkt (8) aus einer Zusammenschaltung von Kondensatoren (9) mit annähernd gleicher Kapazität gebildet ist.

10. Vorrichtung nach Anspruch 8 oder 9,
    **dadurch gekennzeichnet,**
    **dass** die kritische Spannung ($U_{lim}$), bei der das Senden des Abschaltsignals erfolgt, 70V beträgt.

11. Vorrichtung zum Prüfen und Überwachen der Durchgängigkeit eines PEN-Leiters (PEN) für ein dreiphasiges TN-C-S-Stromversorgungssystem (2) mit Außenleitern (L1,L2, L3), einem Neutralleiter (N), einem Schutzleiter (PE) und dem PEN-Leiter (PEN), an welches ein AC-Betriebsmittel (6) einphasig über AC-Anschlussklemmen ($K_{L3}$, $K_N$, $K_{PE}$) an einen der Außenleiter (L3), den Neutralleiter (N) und den Schutzleiter (PE) angeschlossen ist, mit einem AC-Schaltglied (30) zur Trennung des AC-Betriebsmittels (6), **gekennzeichnet durch**

    eine Spannungsmesseinrichtung zur Messung einer ersten und einer zweiten Lastspannung ($U_1$, $U_2$) zwischen dem angeschlossenen Außenleiter (L3) und dem Neutralleiter (N) in einem ersten und einem zweiten Lastfall,
    eine Differenzstrom-Messeinrichtung (24) zur Messung eines in dem Neutralleiter (N) fließenden ersten und zweiten N-Leiter Differenzstroms ($I_{d1}$, $I_{d2}$) in dem ersten und dem zweiten Lastfall,
    eine Auswerteeinrichtung (26), welche ausgelegt ist zur Berechnung einer Schleifenimpedanz ($Z_{Loop}$) aus einer Spannungsänderung ($\Delta U$), gebildet aus der ersten Lastspannung ($U_1$) und der zweiten Lastspannung ($U_2$) geteilt **durch** eine Differenzstrom-Änderung ($\Delta I$), gebildet aus dem ersten N-Leiter Differenzstrom ($I_{d1}$) und dem zweiten N-Leiter Differenzstrom ($I_{d2}$) und zum Senden eines Abschaltsignals (28) an das AC-Schaltglied (30) zum Trennen des angeschlossenen Außenleiters (L3), des Neutralleiters (N) und des Schutzleiters (PE) an dem AC-Betriebsmittel (6), falls der Schleifen-Impedanzwert einen Schleifen-Impedanzgrenzwert ($Z_{lim}$) übersteigt.

12. Vorrichtung nach Anspruch 11,
    **gekennzeichnet durch**
    einen gesonderten, zwischen einem der Außenleiter (L3) und dem Neutralleiter (N) angeordneten, Messzweig (32) mit einem Messwiderstand (34) und einem Schalter (36) zum Schalten des ersten und des zweiten Lastfalls **durch** Öffnen und Schließen des Messzweigs (32).

13. Vorrichtung nach Anspruch 11 oder 12,
    **dadurch gekennzeichnet,**
    **dass** die Differenzstrom-Messeinrichtung (24) ausgelegt ist zur Messung eines Berührungsstroms ($I_b$) an dem inaktivem AC-Betriebsmittel (6).

**Fig. 1a**

EP 4 733 791 A1

Fig. 1b

Fig. 2

**Fig. 3a**

**Fig. 3b**

EP 4 733 791 A1

Fig. 4a

EP 4 733 791 A1

**Fig. 4b**

**Fig. 5**

Fig. 6a

Fig. 6b

EP 4 733 791 A1

Europäisches
Patentamt
European
Patent Office
Office européen
des brevets

# EUROPÄISCHER RECHERCHENBERICHT

Nummer der Anmeldung

EP 25 20 7128

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | GB 2 578 339 A (GREENTEC INTERNATIONAL LTD [GB]) 6. Mai 2020 (2020-05-06) | 1,2,8,9 | INV. G01R31/50 |
| Y | * das ganze Dokument * | 3,10 | H02H5/10 |
| | ----- | | |
| Y | Graham Kenyon: "IET Code of Practice for Electric Vehicle Charging Equipment Installation, 4th Edition", , 1. Mai 2020 (2020-05-01), Seiten 1-21, XP093365025, Gefunden im Internet: URL:https://electrical.theiet.org/media/2418/wiring-matters-issue-80-may-2020.pdf * Section "New guidance on balanced three-phase systems"; Seite 5 * | 3,10 | |
| | ----- | | |
| X | EP 0 909 956 A2 (BEHA C GMBH [DE]) 21. April 1999 (1999-04-21) * das ganze Dokument * | 4-7, 11-13 | |
| | ----- | | |
| A | GB 2 408 809 A (KYORITSU ELECT INST WORK [JP]) 8. Juni 2005 (2005-06-08) * das ganze Dokument * | 4-7, 11-13 | |
| | ----- | | |

| | |
|---|---|
| | RECHERCHIERTE SACHGEBIETE (IPC) |
| | G01R H02H |

Der vorliegende Recherchenbericht wurde für alle Patentansprüche erstellt

| Recherchenort | Abschlußdatum der Recherche | Prüfer |
|---|---|---|
| München | 12. Februar 2026 | Trifonov, Antoniy |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes Dokument

EPO FORM 1503 03.82 (P04C03)

**EP 4 733 791 A1**

**ANHANG ZUM EUROPÄISCHEN RECHERCHENBERICHT
ÜBER DIE EUROPÄISCHE PATENTANMELDUNG NR.**　　　EP 25 20 7128

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-02-2026

| Im Recherchenbericht angeführtes Patentdokument | Datum der Veröffentlichung | Mitglied(er) der Patentfamilie | Datum der Veröffentlichung |
|---|---|---|---|
| GB 2578339 A | 06-05-2020 | AU 2020247540 A1 | 18-11-2021 |
| | | CA 3141957 A1 | 01-10-2020 |
| | | GB 2578339 A | 06-05-2020 |
| | | NZ 781198 A | 24-12-2021 |
| | | WO 2020193942 A1 | 01-10-2020 |
| EP 0909956 A2 | 21-04-1999 | AT E378605 T1 | 15-11-2007 |
| | | DE 19746200 A1 | 20-05-1999 |
| | | EP 0909956 A2 | 21-04-1999 |
| | | US 6288553 B1 | 11-09-2001 |
| GB 2408809 A | 08-06-2005 | GB 2408809 A | 08-06-2005 |
| | | JP 4297774 B2 | 15-07-2009 |
| | | JP 2005164419 A | 23-06-2005 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2020174217 A1
- EP 0806825 A2